# EUROPEAN PATENT APPLICATION

(11) **EP 3 627 561 A1**
(43) Date of publication of application: **25.03.2020**
(21) Application number: 17909674.8
(22) Date of filing: 25.05.2017
(51) Int. Cl.: H01L 31/0224, H01L 31/048, H01L 31/049, H01L 31/18, C23C 16/458, C23C 16/455

(54) **TUBULAR PERC SINGLE-SIDED PHOTOVOLTAIC CELL AND METHOD FOR FABRICATION THEREOF AND DEDICATED DEVICE**

(30) Priority: 18.05.2017 CN 201710353393
(71) Applicant: Guangdong Aiko Solar Energy Technology Co., Ltd., Foshan, Guangdong 528000 (CN); Zhejiang Aiko Solar Enery Technology Co., Ltd., Yiwu, Zhejiang 322009 (CN)
(72) Inventor: FANG, Jiebin, Leping Town, Sanshui District, Foshan, Guangdong 528000 (CN); LIN, Kang-Cheng, Leping Town, Sanshui District, Foshan, Guangdong 528000 (CN); LAI, Chun-Wen, Leping Town, Sanshui District, Foshan, Guangdong 528000 (CN); HE, Nailin, Leping Town, Sanshui District, Foshan, Guangdong 528000 (CN); YIN, Wenjie, Leping Town, Sanshui District, Foshan, Guangdong 528000 (CN); HO, Ta-neng, Leping Town, Sanshui District, Foshan, Guangdong 528000 (CN); CHEN, Gang, Leping Town, Sanshui District, Foshan, Guangdong 528000 (CN)
(74) Representative: Kudlek, Franz Thomas
(86) International application number: PCT/CN2017/086019
(87) International publication number: WO 2018/209728

(57) **Abstract**

A monofacial tube-type PERC solar cell is disclosed, and comprises a rear silver busbar (1), an all-aluminum rear electric field (2), a rear composite film (3), P-type silicon (5), an N-type emitter (6), a front passivation film (7), and a front silver electrode (8). The rear composite film (3) includes one or more of an aluminum oxide film, a silicon dioxide film, a silicon oxynitride film, and a silicon nitride film, and is deposited on a rear surface of a silicon wafer by a tubular PECVD device. The tubular PECVD device includes four gas lines of silane, ammonia, trimethyl aluminum, and nitrous oxide. A graphite boat is employed to load and unload the silicon wafer in the tubular PECVD device, and a pin slot of the graphite boat has a depth of 0.5-1 mm. In addition, a method and a device for preparing the monofacial tube-type PERC solar cell is disclosed. Such monofacial tube-type PERC solar cell has advantages of high photoelectric conversion efficiency, high appearance quality and high electroluminescence yield, and solves the problems of scratching and undesirable coating due to the process.

## Description

### FIELD

The present invention relates to the field of solar cells, and in particular to a monofacial tube-type PERC solar cell, a preparation method thereof, and a production device therefor.

### BACKGROUND

A crystalline silicon solar cell is a device that effectively absorbs solar radiation energy and converts light energy into electrical energy through the photovoltaic effect. When sunlight reaches the p-n junction of a semiconductor, new electron-hole pairs are generated. Under the action of the electric field of the p-n junction, the holes flow from the N zone to the P zone, and the electrons flow from the P zone to the N zone, generating current upon switching on a circuit.

In a conventional crystalline silicon solar cell, surface passivation is basically only performed at the front surface, which involves depositing a layer of silicon nitride on the front surface of the silicon wafer via PECVD to reduce the recombination rate of the minority carriers at the front surface. As a result, the open-circuit voltage and short-circuit current of the crystalline silicon cell can be greatly increased, which leads to an increase of the photoelectric conversion efficiency of the crystalline silicon solar cell.

In order to meet the ever-rising requirements for the photoelectric conversion efficiency of crystalline silicon cells, people began to study the rear surface passivation technologies of solar cells. At present, the mainstream method is to use a plate PECVD system to coat the rear side. The plate PECVD system consists of different chambers; each chamber is used for coating one layer of film. Once the device is fixed, the number of layers of a composite film is fixed. Therefore, a disadvantage of the plate PECVD system is that the combination of layers in the composite film cannot be flexibly adjusted; thus, it is impossible to optimize the passivation effect of the rear surface film, which limits the photoelectric conversion efficiency of the cell. Meanwhile, the plate PECVD system employs an indirect plasma method, which gives a less than ideal passivation effect of the film. The plate PECVD system also has other disadvantages including low uptime and long maintenance time, which affects its capacity and yield.

The present invention employs tubular PECVD technology to deposit a composite film on the rear surface of a silicon wafer in order to produce a monofacial high-efficiency PERC solar cell. Due to the fact that tubular PECVD technology employs a direct plasma method and could flexibly adjust the composition and combination of layers in a composite film, the passivation effect of the film is good, and the photoelectric conversion efficiency of the PERC solar cell can be significantly improved. The excellent passivation ability and process flexibility of tubular PECVD technology also allow the thickness of an aluminum oxide film to be reduced, thus reducing the consumption of TMA. Meanwhile, tubular PERC technology can be easily maintained and has a high uptime. In view of the above, employing tubular PECVD technology to produce high-efficiency PERC cells has a significant overall cost advantage over employing plate PECVD technology.

Despite the above, the cells produced by tubular PECVD technology have poor appearance quality and low electroluminescence (EL) yield due to contradictive problems of undesirable coating and scratching; these drawbacks prevent the application of this technology in mass production.

In a tubular PECVD coating device, a silicon wafer is first inserted into a graphite boat, and then the graphite boat is fed into a quartz tube for coating deposition. In the graphite boat, the silicon wafer is fixed to the graphite boat wall via three pins; one surface of the silicon wafer is in contact with the graphite boat wall, and a film is deposited on the other surface of the silicon wafer. To allow the formation of a uniform coating, the silicon wafer should be in tight contact with the graphite boat wall. Therefore, the width of the pin slot is set to be small; about 0.25 mm. There are two disadvantages in tubular PECVD coating process: 1. during the insertion process, the silicon wafer rubs against the graphite boat wall, which causes that the surface of the silicon wafer adjacent to the graphite boat wall is scratched; 2. during the deposition process, due to the inevitable presence of a gap between the silicon wafer and the graphite boat wall (and in particular a large gap at the pins), the reacting gas would diffuse to the other surface of the silicon wafer and deposits a film on the other surface, leading to undesirable coating; hence, wherein undesirable coating is more serious at the pins.

When using tubular PECVD to coat the front surface of a conventional solar cell, scratching and undesirable coating do not affect the quality of the cell product; the reasons are as follows: 1. there are no p-n junctions and coating at the rear surface of the silicon wafer, and hence, scratches would not affect the electrical performance and the EL yield of the cell; 2. there is no coating on the rear surface of the conventional cell, and hence, the relatively thin undesirable coating at the edge of the rear surface does not appear obvious and does not affect the appearance quality.

On the other hand, when using tubular PECVD to form the rear film of a PERC cell, scratching and undesirable coating would seriously affect the pass rate of the cell product. The problems are as follows: 1. during the deposition of the rear film, undesirable coating would take place at the edge of the front surface; as the PERC cell is coated on both sides, the coating at the edge of the front surface would be relatively thick; consequentially, boat teeth marks and color difference appear at the edge of the front surface of the cell, affecting the appearance quality; 2. when inserted into the graphite boat, the front surface of the silicon wafer would be in contact with the graphite boat wall, scratching the p-n junctions at the front surface; as a result, scratches would be present in the EL test, and the electrical performance of the cell would be affected.

### SUMMARY

An objective of the present invention is to provide a monofacial tube-type PERC solar cell which has high photoelectric conversion efficiency, high appearance quality, and high EL yield, and could solve the problems of both scratching and undesirable coating.

Another objective of the present invention is to provide a method of preparing the monofacial tube-type PERC solar cell, which is simple, can be carried out at a large scale, and is compatible with existing production lines. The cells produced have high appearance quality and high EL yield, and could solve the problems of both scratching and undesirable coating.

Yet another objective of the present invention is to provide a device for producing the monofacial tube-type PERC solar cell. The device has a simple structure, low cost, large capacity and yield. The cells produced have high appearance quality and high EL yield, and could solve the problems of both scratching and undesirable coating.

To achieve the objectives above, the present invention provides a monofacial tube-type PERC solar cell, which comprises a rear silver busbar, an all-aluminum rear electric field, a rear composite film, P-type silicon, an N-type emitter, a front passivation film, and a front silver electrode, wherein the all-aluminum rear electric field, rear composite film, the P-type silicon, the N-type emitter, the front passivation film, and the front silver electrode are stacked and connected sequentially from bottom to top;

the rear composite film includes one or more of an aluminum oxide film, a silicon dioxide film, a silicon oxynitride film, and a silicon nitride film, and is deposited on a rear surface of a silicon wafer by a tubular PECVD device; the tubular PECVD device includes four gas lines of silane, ammonia, trimethyl aluminum, and nitrous oxide; the four gas lines are used alone or in combination to form the aluminum oxide film, the silicon dioxide film, the silicon oxynitride film, and the silicon nitride film; it is possible to obtain a silicon oxynitride film or a silicon nitride film having different composition ratios and refractive indexes by adjusting the ratio of the gas flow rate; a graphite boat is employed to load and unload the silicon wafer in the tubular PECVD device; and a pin slot of the graphite boat has a depth of 0.5-1 mm;

30-500 parallel-arranged laser grooving regions are formed in the rear composite film by laser grooving; each of the laser grooving regions includes at least one group of laser grooving units; and the all-aluminum rear electric field is connected to the P-type silicon via the laser grooving regions.

As an improvement of the technical solution above, the pin slot of the graphite boat has a depth of 0.6- 0.8 mm, a diameter of a pin base is 6-15 mm, an angle of inclination of an inclined surface of a pin cap is 35-45 degrees, and a thickness of the pin cap is 1-1.3 mm.

As an improvement of the technical solution above, 3-5 pin marks are formed on the rear surface of the monofacial tube-type PERC solar cell.

As an improvement of the technical solution above, a bottom layer of the rear composite film is the aluminum oxide film, and a top layer of the rear composite film is composed of one or more of the silicon dioxide film, the silicon oxynitride film, and the silicon nitride film.

As an improvement of the technical solution above, a bottom layer of the rear composite film is the silicon dioxide film, a middle layer of the rear composite film is the aluminum oxide film, and a top layer of the rear composite film is composed of one or more of the silicon dioxide film, the silicon oxynitride film, and the silicon nitride film.

As an improvement of the technical solution above, a thickness of the aluminum oxide film is 5-15 nm, a thickness of the silicon nitride film is 50-150 nm, a thickness of the silicon oxynitride film is 5-20 nm, and a thickness of the silicon dioxide film is 1-10 nm.

Accordingly, the present invention also provides a method of preparing the monofacial tube-type PERC solar cell. The method comprises:
(1) forming textured surfaces at a front surface and the rear surface of the silicon wafer, wherein the silicon wafer is the P-type silicon;
(2) performing diffusion via the front surface of the silicon wafer to form the N-type emitter;
(3) removing phosphosilicate glass and peripheral p-n junctions formed during the diffusion, and polishing the rear surface of the silicon wafer, wherein a depth of rear etching is 3-6 µm;
(4) performing annealing on the silicon wafer, wherein an annealing temperature is 600-820°C, a nitrogen flow rate is 1-15 L/min, and an oxygen flow rate is 0.1-6 L/min;
(5) depositing the rear composite film on the rear surface of the silicon wafer by the tubular PECVD device, including:
   depositing the aluminum oxide film using TMA and N₂O, wherein a gas flow rate of TMA is 250-500 sccm, a ratio of TMA to N₂O is 1 to 15-25, and a plasma power is 2000-5000W;
   depositing the silicon oxynitride film using silane, ammonia, and nitrous oxide, wherein a gas flow rate of silane is 50-200 sccm, a ratio of silane to nitrous oxide is 1 to 10-80, a flow rate of ammonia is 0.1-5 slm, and the plasma power is 4000-6000W;
   depositing the silicon nitride film using silane and ammonia, wherein the gas flow rate of silane is 500-1000 sccm, a ratio of silane to ammonia is 1 to 6-15, a deposition temperature of silicon nitride is 390-410 °C, a deposition time is 300-500s, and the plasma power is 10000-13000W; and
   depositing the silicon dioxide film using nitrous oxide, wherein a flow rate of nitrous oxide is 0.1-5 slm, and the plasma power is 2000-5000W;
   the tubular PECVD device includes four gas lines of silane, ammonia, trimethyl aluminum, and nitrous oxide, the graphite boat is employed to load and unload the silicon wafer in the tubular PECVD device, and the pin slot of the graphite boat has a depth of 0.5-1 mm;
(6) depositing a passivation film on the front surface of the silicon wafer;
(7) performing laser grooving in the rear composite film of the silicon wafer;
   wherein a laser wavelength is 532 nm, a laser power is 14W or more, a laser scribing speed is 20 m/s or more, and a frequency is 500 kHZ or more;
(8) printing with a paste for the rear silver busbar on the rear surface of the silicon wafer, and baking;
(9) printing, using a screen, an aluminum paste on the rear surface of the silicon wafer, and baking;
(10) printing with a paste for the front silver electrode on the front surface of the silicon wafer;
(11) sintering the silicon wafer at a high temperature to form the rear silver busbar, the all-aluminum rear electric field, and the front silver electrode; and
(12) performing anti-LID annealing on the silicon wafer to obtain the monofacial tube-type PERC solar cell.

As an improvement of the technical solution above, depositing the rear composite film on the rear surface of the silicon wafer by the tubular PECVD device comprises:
depositing the aluminum oxide film using TMA and N₂O, wherein the gas flow rate of TMA is 250-500 sccm, the ratio of TMA to N₂O is 1 to 15-25, a deposition temperature of the aluminum oxide film is 250-300 °C, a deposition time is 50-300s, and the plasma power is 2000-5000W;
depositing the silicon oxynitride film using silane, ammonia, and nitrous oxide, wherein the gas flow rate of silane is 50-200 sccm, the ratio of silane to nitrous oxide is 1 to 10-80, the flow rate of ammonia is 0.1-5 slm, a deposition temperature of the silicon oxynitride film is 350-410 °C, a deposition time is 50-200s, and the plasma power is 4000-6000W;
depositing the silicon nitride film using silane and ammonia, wherein the gas flow rate of silane is 500-1000 sccm, the ratio of silane to ammonia is 1 to 6-15, the deposition temperature of the silicon nitride film is 390-410 °C, the deposition time is 300-500s, and the plasma power is 10000-13000W; and
depositing the silicon dioxide film using nitrous oxide, wherein the flow rate of nitrous oxide is 0.1-5 slm, and the plasma power is 2000-5000W.

Accordingly, the present invention also provides a device for producing the monofacial tube-type PERC solar cell. The device is the tubular PECVD device, which includes a wafer loading area, a furnace body, a gas cabinet, a vacuum system, a control system, and a graphite boat, the gas cabinet including a first gas line for feeding silane, a second gas line for feeding ammonia, a third gas line for feeding trimethylaluminum, and a fourth gas line for feeding nitrous oxide;

the graphite boat is employed for loading and unloading the silicon wafer, wherein the graphite boat includes a pin which includes a pin shaft, a pin cap connected to the pin shaft, and a pin base on which the pin shaft is mounted, and wherein a pin slot is formed among the pin shaft, the pin cap, and the pin base, and a depth of the pin slot is 0.5-1 mm.

As an improvement of the technical solution above, the depth of the pin slot is 0.6-0.8 mm, a diameter of the pin base is 6-15 mm, an angle of inclination of an inclined surface of the pin cap is 35-45 degrees, and a thickness of the pin cap is 1-1.3 mm.

The present invention has the following beneficial effects:
First, the present invention employs a tubular PECVD device to deposit the rear composite film on the rear surface of the silicon wafer. The rear composite film includes one or more of an aluminum oxide film, a silicon dioxide film, a silicon oxynitride film, and a silicon nitride film. The tubular PERC device adopts a direct plasma method in which the plasma directly bombards the surface of the silicon wafer and causes significant passivation of the film. The tubular PECVD device includes four gas lines of silane, ammonia, trimethyl aluminum, and nitrous oxide, which are used alone or in combination to form the aluminum oxide film, the silicon dioxide film, the silicon oxynitride film, and the silicon nitride film. By employing different gas combinations, different ratios of the gas flow rate, and different deposition time, the four gas lines of silane, ammonia, trimethyl aluminum, and nitrous oxide may form different films. As to a silicon oxynitride film or a silicon nitride film, it is possible to obtain a silicon oxynitride film or a silicon nitride film having different composition ratios and refractive indexes by adjusting the ratio of the gas flow rate. The combination order, thickness, and composition of the composite film can be flexibly adjusted, and therefore the production process of the present invention is flexible and controllable; furthermore, it is possible to reduce cost and obtain a large yield with this production process. In addition, the rear composite film is optimized to match the all-aluminum rear electric field at the rear surface, which gives the best passivation effect and significantly increases the photoelectric conversion efficiency of the PERC cell.
Second, the present invention adjusts the diameters of the pin shaft and the pin base to reduce the depth of the inside of the pin slot. As a result, the gap between the silicon wafer and the pin base at the position of the pin is reduced. Further, the amount of gas reaching and coating the rear surface of the silicon wafer is reduced, and boat teeth marks at the front surface edges of the cell thus are much less likely to occur. In addition, the present invention adequately increases the angle of inclination of the inclined surface of the pin cap and the thickness of the pin cap, and adjusts the automatic wafer inserter, thereby slightly increasing the distance between the silicon wafer and the graphite boat wall on inserting the wafer, and reducing scratching. Increasing the angle of inclination of the inclined surface of the pin cap may also reduce the impact force on the silicon wafer from the graphite boat wall when the silicon wafer is sliding down, reducing breakage rate.

Furthermore, silicon nitride is the outer layer of the rear composite film; and as the deposition time increases, the thickness of the film at the surface of the silicon wafer increases, which causes silicon wafer to bend. As a result, it is easier for silane and ammonia to be coated to the front surface edge of the cell. In the present invention, the deposition temperature for silicon nitride is set to 390-410 °C, and the deposition time is set within 300-500s. By shortening the time and temperature of silicon nitride deposition, the bending of the silicon wafer can be reduced, and thus the amount of the undesirable coating can be reduced. The temperature window for silicon nitride deposition is very narrow, between 390-410 °C, which may allow the maximum reduction of the undesirable coating. When the deposition temperature is below 390°C, the amount of the undesirable coating increases, however.

Meanwhile, to meet the requirements of large-scale production and minimize the negative impact caused by shortening the silicon nitride deposition time, the present invention sets a laser power of 14W or more, a laser scribing speed of 20 m/s or more, and a frequency of 500 kHZ or more. This allows the absorption of a sufficiently large amount of laser energy per unit of area of the rear composite film to effectively groove the composite film, thereby ensuring that the aluminum paste subsequently printed is in contact with the silicon substrate through the laser grooving regions.

To conclude, the monofacial tube-type PERC solar cell of the present invention has high photoelectric conversion efficiency, high appearance quality, and high EL yield; and further, it solves the problems of both scratching and undesirable coating. In addition, the present invention also provides a method and a device for the production of the aforementioned cell. The production method is simple and compatible with existing production lines, and can be carried out at a large scale. The production device has a simple structure, low cost, large capacity and yield.

### BRIEF DESCRIPTION OF THE DRAWINGS

FIG. 1 is a sectional view of a monofacial tube-type PERC solar cell of the present invention;
Fig. 2 is a schematic diagram of the rear structure of the monofacial tube-type PERC solar cell of FIG. 1;
FIG. 3 is a schematic diagram of the first embodiment of the rear composite film of FIG. 1;
FIG. 4 is a schematic diagram of the second embodiment of the rear composite film of FIG. 1;
FIG. 5 is a schematic diagram of the third embodiment of the rear composite film of FIG. 1;
FIG. 6 is a schematic diagram of the fourth embodiment of the rear composite film of FIG. 1;
FIG. 7 is a schematic diagram of the fifth embodiment of the rear composite film of FIG. 1;
FIG. 8 is a schematic diagram of the sixth embodiment of the rear composite film of FIG. 1;
FIG. 9 is a schematic diagram of a device for producing the monofacial tube-type PERC solar cell of the present invention;
FIG. 10 is a schematic diagram of the graphite boat shown in FIG. 9;
FIG. 11 is a schematic diagram of a pin of the graphite boat shown in FIG. 10.

### DETAILED DESCRIPTION OF EMBODIMENTS

To more clearly illustrate the objectives, technical solutions and advantages of the present invention, the present invention will be further described in detail below with reference to the accompanying drawings.

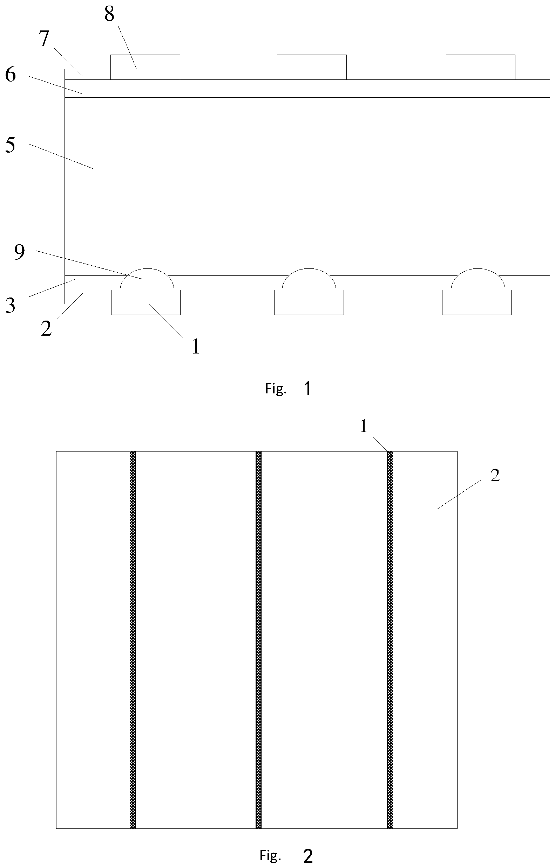

As shown in FIGS. 1 and 2, the present invention provides a monofacial tube-type PERC solar cell, which includes a rear silver busbar 1, an all-aluminum back electric field 2, a rear composite film 3, P-type silicon 5, an N-type emitter 6, a front passivation film 7, and a front silver electrode 8. The all-aluminum back electric field 2, the rear composite film 3, the P-type silicon 5, the N-type emitter 6, the front passivation film 7, and the front silver electrode 8 are stacked and connected sequentially from bottom to top. By laser grooving, 30-500 groups of parallel-arranged laser grooving regions are formed in the rear composite film 3, at least one group of laser grooving units 9 is arranged in each laser grooving region, and the all-aluminum back electric field 2 is connected to the P-type silicon 5 via the laser grooving region.

It should be noted that the pattern of the laser grooving unit 9 is circular, elliptical, triangular, quadrangular, pentagonal, hexagonal, cruciform or star-shaped.

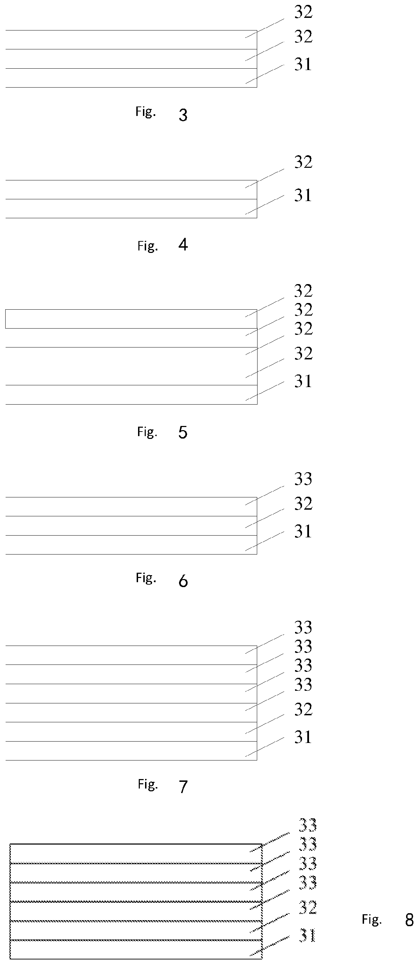

The present invention employs a tubular PECVD device to deposit the rear composite film on the rear surface of the silicon wafer. The tubular PERC device employs a direct plasma method in which the plasma directly bombards the surface of the silicon wafer and causes significant passivation of the film. As shown in FIGS. 3-8, the rear composite film 3 includes one or more of an aluminum oxide (Al₂O₃) film, a silicon dioxide film, a silicon oxynitride film, and a silicon nitride film, and is deposited at the rear surface of the silicon wafer by a tubular PECVD device. The tubular PECVD device includes four gas lines of silane, ammonia, trimethyl aluminum, and nitrous oxide; and the four gas lines are used alone or in combination to form the aluminum oxide film, the silicon dioxide film, the silicon oxynitride film, and the silicon nitride film. By adjusting the ratio of the gas flow rate, it is possible to obtain a silicon oxynitride film or a silicon nitride film having different composition ratios and refractive indexes. The order of formation and the thickness of the aluminum oxide film, the silicon dioxide film, the silicon oxynitride film, and the silicon nitride film are adjustable; and the composition and refractive index of the silicon oxynitride film and the silicon nitride film are adjustable.

The four gas lines of silane, ammonia, trimethylaluminum, and nitrous oxide can form different films with different gas combinations, different gas flow ratios, and different deposition time. As to the silicon oxynitride film or the silicon nitride film, by adjusting the ratio of the gas flow rate, it is possible to obtain the silicon oxynitride film or the silicon nitride film having different composition ratios and refractive indexes. The combining order, thickness, and composition of the composite film can be flexibly adjusted, and therefore the production process of the present invention is flexible and controllable; furthermore, it is possible to reduce cost and obtain a large yield with this production process. In addition, the rear composite film is optimized to match the all-aluminum rear electric field at the rear surface, which gives the best passivation effect and significantly increases the photoelectric conversion efficiency of the PERC cell.

The apparatus for loading and unloading silicon wafers in the tubular PECVD device is a graphite boat. The pin slot of the graphite boat has a depth of 0.5-1 mm. Preferably, the depth of the pin slot of the graphite boat is 0.6-0.8 mm; the diameter of a pin base is 6-15 mm; the angle of inclination of an inclined surface of a pin cap is 35-45 degrees; the thickness of the pin cap is 1-1.3 mm. More preferably, the pin slot of the graphite boat has a depth of 0.7-0.8 mm; the diameter of the pin base is 8-12 mm; the angle of inclination of an inclined surface of a pin cap is 35-40 degrees; and the thickness of the pin cap is 1- 1.2mm.

When employing tubular PECVD for rear film deposition, scratching and undesirable coating are contradictive. By adjusting an automatic wafer inserter, the silicon wafer can be inserted into the pin slot without contacting the graphite boat wall, during which the silicon wafer is kept at a distance from the graphite boat to avoid friction between the silicon wafer and the graphite boat wall. If the distance between the silicon wafer and the graphite boat plate were too large, scratching would be less likely to take place, but the possibility of the undesirable coating would increase as the silicon wafer would be less easy to be close to the boat wall. If the distance between the silicon wafer and the graphite boat plate were too large, the silicon wafer may be prevented from being inserted into the pin slot, and the silicon wafer may fall off as a result. If the distance between the silicon wafer and the graphite boat plate were too small, the silicon wafer would be closer to the graphite boat plate. As a result, undesirable coating would be less likely to take place, but the possibility of scratching would increase.

The position of the boat teeth mark at the edge of the front surface of the cell corresponds to the position of the pin during coating the rear surface by PECVD. The mark is formed as a result of gas flowing to the front surface of the cell from the position of the pin. Since the thickness of the pin base is slightly smaller than the thickness of the graphite boat plate, there is a gap between the silicon wafer and the pin base at the position of the pin. When coating the rear surface, the gas enters the gap from two sides below the pin shaft, which causes a film deposited at the front surface edge of the silicon wafer, i.e., forming a semi-circular boat teeth mark.

The present invention adjusts the diameters of the pin shaft and the pin base to reduce the depth of the inside of the pin slot. As a result, the gap between the silicon wafer and the pin base at the position of the pin is reduced; consequentially, the amount of gas reaching and coating the rear surface of the silicon wafer is reduced, and boat teeth marks at the front surface edges of the cell are thus much less likely to occur.

By adjusting the automatic wafer inserter, after inserting the silicon wafer into a certain position in the graphite boat, the suction cup releases its vacuum and thus the silicon wafer falls onto the inclined surface of the pin cap. As an effect of gravity, the silicon wafer slides down the inclined surface until it is close to the graphite boat wall. This type of insertion is contactless and could reduce scratching of the silicon wafer.

The present invention adequately increases the angle of inclination of the inclined surface of the pin cap and the thickness of the pin cap, and adjusts the automatic wafer inserter, thereby slightly increasing the distance between the silicon wafer and the graphite boat wall on inserting the wafer, reducing scratching. Increasing the angle of inclination of the inclined surface of the pin cap may also reduce the impact force on the silicon wafer from the graphite boat wall when the silicon wafer is sliding down, reducing breakage rate.

The tubular PECVD device employs the graphite boat for loading and unloading silicon wafers, and pin marks are formed on the rear surface of the cell. Specifically, 3-5 pin marks are formed on the rear surface of the cell.

The rear composite film 3 has various embodiments. Referring to FIGS. 3, 4 and 5, the bottom layer of the rear composite film is an aluminum oxide film, and the top layer is composed of one or more of a silicon dioxide film, a silicon oxynitride film, and a silicon nitride film.

In the first embodiment of the rear composite film shown in FIG. 3, the bottom layer 31 of the rear composite film 3 is an aluminum oxide film; and the top layer 32 of the rear composite film is composed of a silicon oxynitride film and a silicon nitride film.

In the second embodiment of the rear composite film shown in FIG. 4, the bottom layer 31 of the rear composite film is an aluminum oxide film; and the top layer 32 of the rear composite film is a silicon nitride film.

In the third embodiment of the rear composite film shown in FIG. 5, the bottom layer 31 of the rear composite film is an aluminum oxide film; and the top layer 32 of the rear composite film is composed of a silicon dioxide film, a silicon oxynitride film A, a silicon oxynitride film B, and a silicon nitride film.

Referring to FIGS. 6, 7 and 8, the bottom layer 31 of the rear composite film is a silicon dioxide film; the middle layer 32 of the rear composite film is an aluminum oxide film; and the top layer 33 is composed of one or more of a silicon dioxide film, a silicon oxynitride film, and a silicon nitride film.

In the fourth embodiment of the rear composite film shown in FIG. 6, the bottom layer 31 of the rear composite film is a silicon dioxide film, the middle layer 32 of the rear composite film is an aluminum oxide film, and the top layer 33 of the rear composite film is a silicon nitride film.

In the fifth embodiment of the rear composite film shown in FIG. 7, the bottom layer 31 of the rear composite film is a silicon dioxide film, the middle layer 32 of the rear composite film is an aluminum oxide film, and the top layer 33 of the rear composite film is composed of a silicon dioxide film, a silicon oxynitride film A, a silicon oxynitride film B, and a silicon nitride film.

In the sixth embodiment of the rear composite film shown in FIG. 8, the bottom layer 31 of the rear composite film is a silicon dioxide film, the middle layer 32 of the rear composite film is an aluminum oxide film, and the top layer 33 is composed of a silicon dioxide film, a silicon oxynitride film, a silicon nitride film A, and a silicon nitride film B.

Specifically, the thickness of the aluminum oxide film is 5-15 nm, the thickness of the silicon nitride film is 50-150 nm, the thickness of the silicon oxynitride film is 5-20 nm, and the thickness of the silicon dioxide film is 1-10 nm. The actual thickness of the aluminum oxide film, the silicon nitride film, the silicon oxynitride film, and the silicon dioxide film may be adjusted according to actual needs; their embodiments are not limited to the embodiments described in the present invention.

To conclude, the monofacial tube-type PERC solar cell of the present invention has high photoelectric conversion efficiency, high appearance quality, and high EL yield, and further solves the problems of both scratching and undesirable coating.

It should be noted that EL (electroluminescence) is used for testing the appearance and the electrical performance. It is possible to use EL to check potential defects of crystalline silicon solar cells and their modules. EL could effectively detect whether a cell has breakage, cracks, broken grid lines, scratches, sintering defects, dark spots, mixing of different grades of cells, inhomogeneous resistance of the cell, and others.

Accordingly, the present invention also discloses a method of preparing a monofacial tube-type PERC solar cell, comprising the following steps:
(1) Forming textured surfaces at the front and rear surfaces of the silicon wafer, wherein the silicon wafer is P-type silicon.
   Using wet etching or dry etching techniques, a textured surface is formed at the surface of the silicon wafer by a texturing device.
(2) Performing diffusion via the front surface of the silicon wafer to form an N-type emitter.
   The diffusion process adopted by the preparation method of the present invention involves placing the silicon wafer in a thermal diffusion furnace for diffusion to form an N-type emitter on the P-type silicon. During diffusion, the temperature is controlled within a range of 800 °C to 900 °C. The target sheet resistance is 70-100 ohms/□.
   At the rear surface of a tube-type PERC cell, the P-type silicon is in contact with the aluminum paste only at the laser regions, instead of over the whole rear surface, which results in higher series resistance. In order to improve the performance of the tube-type PERC cell, the present invention adopts a lower diffusion sheet resistance (70-100 ohms/D), which may reduce series resistance and increase photoelectric conversion efficiency.
   During the diffusion process, phosphosilicate glass layers are formed on the front and rear surfaces of the silicon wafer. The phosphosilicate glass layers form as a result of the reaction between POCl₃ and O₂ to form a P₂O₅ deposition on the surface of the silicon wafer during the diffusion process. P₂O₅ reacts with Si to form SiO₂ and phosphorus atoms, and thus a layer of SiO₂ containing phosphorus is formed on the surface of the silicon wafer, which is called phosphosilicate glass. The phosphosilicate glass layer could collect the impurities in the silicon wafer during diffusion and could further reduce the content of impurities in the solar cell.
(3) Removing the phosphosilicate glass and peripheral p-n junctions formed during diffusion, and polishing the rear surface of the silicon wafer, wherein the depth of rear etching is 3-6 µm.
   In the invention, the diffused silicon wafer is immersed in an acid bath of a mixed solution of HF (mass percentage 40%-50%) and HNO₃ (mass percentage 60%-70%) in a volume ratio of 1 to 5-8 for 5-30 seconds to remove the phosphosilicate glass and the peripheral p-n junctions. The phosphosilicate glass layer probably causes a color difference in PECVD and causes SiₓN_{y} to peel off; in addition, the phosphosilicate glass layer contains a large amount of phosphorus and impurities migrated from the silicon wafer, and thus it is necessary to remove the phosphosilicate glass layer.
   The etching depth of a conventional cell is about 2µm. The present invention adopts a rear surface etching depth of 3 to 6µm. By increasing the etching depth of the tube-type PERC cell, the reflectance of the rear surface, the short-circuit current, and the photoelectric conversion efficiency of the cell can be improved accordingly.
(4) Performing annealing on the silicon wafer, wherein the annealing temperature is 600-820°C, the nitrogen flow rate is 1-15 L/min, and the oxygen flow rate is 0.1-6 L/min. The annealing step may improve the doping concentration distribution at the front surface of the silicon wafer and reduce surface defects caused by doping.
(5) Depositing the rear composite film on the rear surface of the silicon wafer using a tubular PECVD device, including:
   depositing an aluminum oxide film using TMA and N₂O, wherein the gas flow rate of TMA is 250-500 sccm, the ratio of TMA to N₂O is 1 to 15-25, and the plasma power is 2000-5000W;
   depositing a silicon oxynitride film using silane, ammonia, and nitrous oxide, wherein the gas flow rate of silane is 50-200 sccm, the ratio of silane to nitrous oxide is 1 to 10-80, the flow rate of ammonia is 0.1-5 slm, and the plasma power is 4000-6000W;
   depositing a silicon nitride film using silane and ammonia, wherein the gas flow rate of silane is 500-1000sccm, the ratio of silane to ammonia is 1 to 6-15, the deposition temperature of silicon nitride is 390-410 °C, the deposition time is 300-500s, and the plasma power is 10000-13000W; and
   depositing a silicon dioxide film using nitrous oxide, wherein the flow rate of nitrous oxide is 0.1-5 slm, and the plasma power is 2000-5000W.

The tubular PECVD device includes four gas lines of silane, ammonia, trimethyl aluminum, and nitrous oxide. The apparatus for loading and unloading silicon wafers in the tubular PECVD device is a graphite boat. The pin slot of the graphite boat has a depth of 0.5-1 mm.

As a preferred embodiment of this step, depositing the rear composite film on the rear surface of the silicon wafer using a tubular PECVD device includes:
depositing an aluminum oxide film using TMA and N₂O, wherein the gas flow rate of TMA is 250-500 sccm, the ratio of TMA to N₂O is 1 to 15-25, the deposition temperature of the aluminum oxide film is 250-300°C, the deposition time is 50-300s, and the plasma power is 2000-5000 W;
depositing a silicon oxynitride film using silane, ammonia, and nitrous oxide, wherein the gas flow rate of silane is 50-200 sccm, the ratio of silane to nitrous oxide is 1 to 10-80, the flow rate of ammonia is 0.1-5 slm, the deposition temperature of the silicon oxynitride film is 350-410°C, the deposition time is 50-200s, and the plasma power is 4000-6000 W;
depositing a silicon nitride film using silane and ammonia, wherein the gas flow rate of silane is 500-1000 sccm, the ratio of silane to ammonia is 1 to 6-15, the deposition temperature of the silicon nitride film is 390-410 °C, the deposition time is 300-500s, and the plasma power is 10000-13000 W; and
depositing a silicon dioxide film using nitrous oxide, wherein the flow rate of nitrous oxide is 0.1-5 slm, and the plasma power is 2000-5000 W.

As a more preferred embodiment of this step, depositing the rear composite film on the rear surface of the silicon wafer using a tubular PECVD device includes:
depositing an aluminum oxide film using TMA and N₂O, wherein the gas flow rate of TMA is 350-450 sccm, the ratio of TMA to N₂O is 1 to 18-22, the deposition temperature of the aluminum oxide film is 270-290 °C, the deposition time is 100-200s, and the plasma power is 3000-4000 W;
depositing a silicon oxynitride film using silane, ammonia, and nitrous oxide, wherein the gas flow rate of silane is 80-150 sccm, the ratio of silane to nitrous oxide is 1 to 20-40, the flow rate of ammonia is 1-4 slm, the deposition temperature for the silicon oxynitride film is 380-410°C, the deposition time is 100-200s, and the plasma power is 4500-5500 W;
depositing a silicon nitride film using silane and ammonia, wherein the gas flow rate of silane is 600-800 sccm, the ratio of silane to ammonia is 1 to 6-10, the deposition temperature of the silicon nitride film is 395-405 °C, the deposition time is 350-450s, and the plasma power is 11000-12000 W; and
depositing a silicon dioxide film using nitrous oxide, wherein the flow rate of nitrous oxide is 1-4 slm, and the plasma power is 3000-4000 W.

As the optimum embodiment of this step, depositing the rear composite film on the rear surface of the silicon wafer using a tubular PECVD device includes:
depositing an aluminum oxide film using TMA and N₂O, wherein the gas flow rate of TMA is 400 sccm, the ratio of TMA to N₂O is 1 to 18, the deposition temperature of the aluminum oxide film is 280°C, the deposition time is 140s, and the plasma power is 3500 W;
depositing an silicon oxynitride film using silane, ammonia, and nitrous oxide, wherein the gas flow rate of silane is 130 sccm, the ratio of silane to nitrous oxide is 1 to 32, the flow rate of ammonia is 0.5 slm, the deposition temperature for the silicon oxynitride film is 420 °C, the deposition time is 120s, and the plasma power is 5000 W;
depositing a silicon nitride film using silane and ammonia, wherein the gas flow rate of silane is 780 sccm, the ratio of silane to ammonia is 1 to 8.7, the deposition temperature of the silicon nitride film is 400 °C, the deposition time is 350s, and the plasma power is 11500 W; and
depositing a silicon dioxide film using nitrous oxide, wherein the flow rate of nitrous oxide is 2 slm, and the plasma power is 3500 W.

The applicant discovered that undesirable coating mainly occurs during the deposition of silicon nitride. This is because silicon nitride is the outer (top) layer of the rear composite film; and as the deposition time increases, the thickness of the film at the surface of the silicon wafer increases, which causes the silicon wafer to bend. As a result, silane and ammonia are probably coated to the front surface edge of the cell. By shortening the time and temperature of silicon nitride deposition, the bending of the silicon wafer can be reduced, and thus the amount of the undesirable coating can be reduced. Further experiments have shown that the temperature window for silicon nitride deposition is very narrow, between 390-410 degrees; when the temperature is further lowered, the amount of the undesirable coating increases, however.

When depositing the aluminum oxide film, the plasma power is set to 2000-5000 W; when depositing the silicon oxynitride film, the plasma power is set to 4000-6000 W; when depositing the silicon nitride film, the plasma power is set to 10000-13000 W; and when depositing the silicon dioxide film, the plasma power is set to 2000-5000 W. This ensures that different layers have good deposition rates and improves deposition uniformity.

Further, the tubular PECVD device includes four gas lines of silane, ammonia, trimethyl aluminum, and nitrous oxide. The apparatus for loading and unloading silicon wafers in the tubular PECVD device is a graphite boat. The pin slot of the graphite boat has a depth of 0.5-1 mm. The technical details of the graphite boat are the same as described above and will not be described in detail here.
(6) Depositing a passivation film on the front surface of the silicon wafer, wherein the passivation film is preferably a silicon nitride film.
(7) Performing laser grooving in the rear composite film of the silicon wafer.
   Laser grooving technique is used to groove the rear composite film of the silicon wafer, in which the depth of the groove reaches the lower surface of the P-type silicon. The laser wavelength is 532 nm, the laser power is 14W or more, the laser scribing speed is 20 m/s or more, and the frequency is 500 kHZ or more.
   Preferably, the laser wavelength is 532 nm, the laser power is 14-20W, the laser scribing speed is 20-30 m/s, and the frequency is 500 KHZ or more.
   As the deposition time of silicon nitride is shortened, the thickness of the silicon nitride film is decreased, which affects the hydrogen passivation effect of the rear composite film layer and lowers the photoelectric conversion efficiency of the cell. Therefore, the silicon nitride deposition time cannot be too short. In addition, the thinner the silicon nitride film, the lower the absorption rate of the laser; meanwhile, in order to meet the requirements of large-scale production, the laser scribing speed must be kept at 20m/s, and the laser power must be kept at 14 W or more. As a result, the power and frequency of the laser must meet certain criteria in order to allow the absorption of a sufficiently large amount of laser energy per unit of area of the rear composite film to effectively groove the composite film, thereby ensuring that the aluminum paste subsequently printed is in contact with the silicon substrate through the laser grooving regions.
(8) Printing with a paste for rear silver busbar on the rear surface of the silicon wafer, and baking.
   A paste for rear silver busbar is printed according to a pattern of the rear silver busbar. The pattern of the rear silver busbar is a continuous straight grid line; and alternatively, the rear silver busbar is arranged in spaced segments, wherein the adjacent segments are connected by a connecting wire.
(9) Printing, using a screen, aluminum paste on the rear surface of the silicon wafer, and baking.
(10) Printing with paste for a front silver electrode on the front surface of the silicon wafer.
(11) Sintering the silicon wafer at a high temperature to form the rear silver busbar, an all-aluminum back electric field, and the front silver electrode.
(12) Performing anti-LID annealing on the silicon wafer to obtain the monofacial tube-type PERC solar cell product.

The preparation method is simple. The production process is flexible and controllable. The combination order, thickness, and composition of the composite film can be flexibly adjusted. It is possible to reduce cost and obtain a large yield, and the preparation method is compatible with existing production lines. The monofacial tube-type PERC solar cell produced by the preparation method has high photoelectric conversion efficiency, high appearance quality, and high EL yield; and further, it solves the problems of both scratching and undesirable coating.

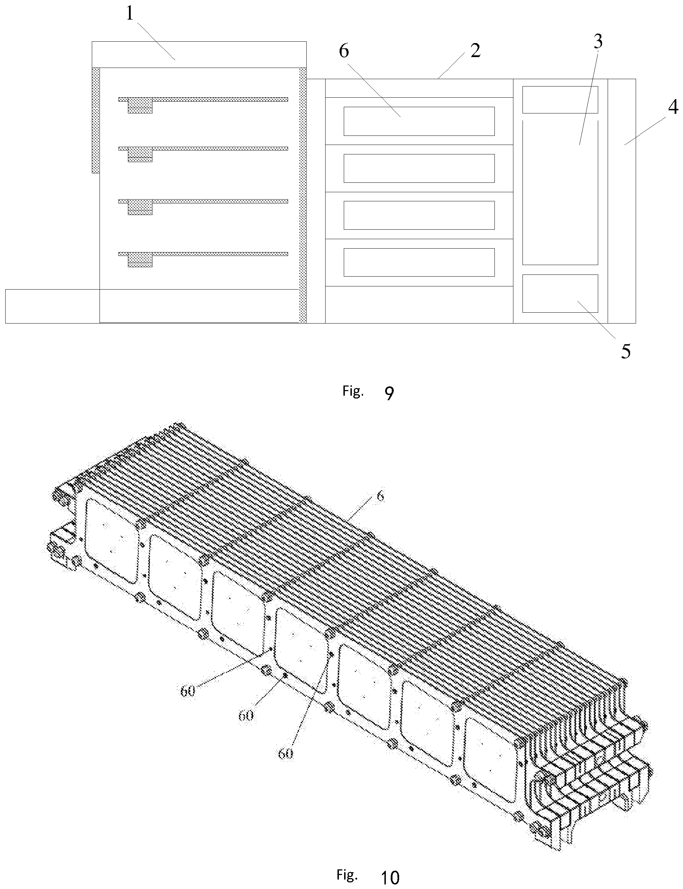

As shown in FIG. 9, the present invention also discloses a production device for the monofacial tube-type PERC solar cell. The device is a tubular PECVD device, which includes a wafer loading area 1, a furnace body 2, a gas cabinet 3, a vacuum system 4, a control system 5, and a graphite boat 6. The gas cabinet 3 includes a first gas line for feeding silane, a second gas line for feeding ammonia, a third gas line for feeding trimethylaluminum, and a fourth gas line for feeding nitrous oxide. The first gas line, the second gas line, the third gas line, and the fourth gas line are provided inside the gas cabinet 3, which are not shown in the figure.

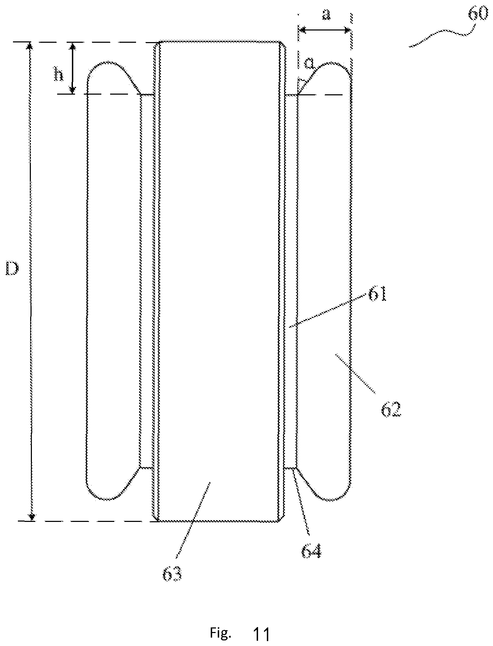

As shown in FIGS. 10 and 11, the graphite boat 6 is used for loading and unloading silicon wafers. The graphite boat 6 includes a pin 60 which includes a pin shaft 61, a pin cap 62, and a pin base 63. The pin shaft 61 is mounted on the pin base 63. The pin cap 62 is connected to the pin shaft 61. A pin slot 64 is formed among the pin shaft 61, the pin cap 62, and the pin base 63. The depth of the pin slot 64 is 0.5-1 mm.

As shown in FIG. 11, the depth of the pin slot 64, h, is preferably 0.6-0.8 mm; the diameter of the pin base 63, D, is preferably 6-15 mm; the angle of inclination of the inclination surface of the pin cap 62, α, is preferably 35-45 degrees; and the thickness of the pin cap 62, a, is preferably 1-1.3 mm.

More preferably, the depth of the pin slot 64, h, is 0.7 mm; the diameter of the pin base 63, D, is 9 mm; the angle of inclination of the inclination surface of the pin cap 62, α, is 40 degrees; and the thickness of the pin cap 62, a, is 1.2 mm.

It should be noted that the depth h of the pin slot is the depth of the inside of the pin slot, and mainly refers to the depth of the side of the pin shaft 61 that forms an angle with the pin base 63. The depth h of the pin slot = (the diameter of the pin base - the diameter of the pin shaft) / 2. The angle of inclination of the inclination surface of the pin cap 62, α, refers to the angle between the inclination surface of the pin cap and the vertical direction.

In the prior art, the depth h of the pin slot is 1.75 mm, the diameter D of the pin base is 9 mm, the angle of inclination α of the inclination surface of the pin cap is 30 degrees, and the thickness a of the pin cap is 1 mm. In the prior art, the pin slot is deeper, which leads to a too big gap between the silicon wafer and the pin base at the position of the pin; and as a result, a lot of gas reaches and is coated on the rear surface of the silicon wafer, leading to the formation of a large number of boat teeth marks at the front surface edge of the cell. The pin cap has a small angle of inclination and a small thickness, leading to small adjustment room for the automatic wafer inserter; and consequentially, it is difficult to effectively lower the occurrence of scratching.

When employing tubular PECVD for rear film deposition, scratching and undesirable coating are contradictive. By adjusting an automatic wafer inserter, the silicon wafer can be inserted into the pin slot without contacting the graphite boat wall, during which the silicon wafer is kept at a distance from the graphite boat to avoid friction between the silicon wafer and the graphite boat wall. If the distance between the silicon wafer and the graphite boat plate were too large, scratching would be less likely to take place, but the possibility of the undesirable coating would increase as the silicon wafer would be less easy to be close to the boat wall. If the distance between the silicon wafer and the graphite boat plate were too large, the silicon wafer may be prevented from being inserted into the pin slot, and the silicon wafer may fall off as a result. If the distance between the silicon wafer and the graphite boat plate were too small, the silicon wafer would be closer to the graphite boat plate. As a result, undesirable coating would be less likely to take place, but the possibility of scratching would increase.

The position of the boat teeth mark at the edge of the front surface of the cell corresponds to the position of the pin during coating the rear surface by PECVD. The mark is formed as a result of gas flowing to the front surface of the cell from the position of the pin. Since the thickness of the pin base is slightly smaller than the thickness of the graphite boat plate, there is a gap between the silicon wafer and the pin base at the position of the pin. When coating the rear surface, the gas enters the gap from two sides below the pin shaft, which causes a film deposited at the front surface edge of the silicon wafer, i.e., forming a semi-circular boat teeth mark.

The present invention adjusts the diameter D of the pin base and the diameter of the pin shaft to reduce the depth h of the inside of the pin slot. As a result, the gap between the silicon wafer and the pin base at the position of the pin is reduced; consequentially, the amount of gas reaching and coating the rear surface of the silicon wafer is reduced, and boat teeth marks at the front surface edges are thus much less likely to occur.

By adjusting the automatic wafer inserter, after inserting the silicon wafer into a certain position in the graphite boat, the suction cup releases its vacuum and thus the silicon wafer falls onto the inclined surface α of the pin cap. As an effect of gravity, the silicon wafer slides down the inclined surface until it is close to the graphite boat wall. This type of insertion is contactless and could reduce scratching of the silicon wafer.

The present invention adequately increases the angle of inclination α of the inclined surface of the pin cap and the thickness a of the pin cap, and adjusts the automatic wafer inserter, thereby slightly increasing the distance between the silicon wafer and the graphite boat wall on inserting the wafer, reducing scratching. Increasing the angle of inclination of the inclined surface of the pin cap reduces the impact force on the silicon wafer from the graphite boat wall when the silicon wafer is sliding down, reducing breakage rate.

It should be noted that in the prior art, the problem of undesirable coating is typically tackled after the production is completed. For example, in the alkali polishing method during the production of PERC crystalline silicon solar cells disclosed in Chinese patent application No. 201510945459.3, after coating a silicon nitride film on the front surface by PECVD, the undesirable silicon nitride coating at the rear surface and the edges is removed by a belt-type transmission etching method, thereby solving the present problems of poor passivation at the rear surface due to undesirable coating formed during depositing the front film, and others. However, in the tube-type PERC cell of the present application, undesirable coating takes place at the front surface during depositing the rear coating; and p-n junctions present at the front surface would be destroyed if the alkali polishing method of the above patent were used. By adjusting the coating process and the coating structure, the present invention can avoid undesirable coating during the production process and solve the problem of undesirable coating from its root. No additional process is required, which simplifies the overall process and reduces production cost. The invention is of great importance for the solar photovoltaic industry, which is extremely cost-sensitive. Moreover, the present invention also solves the problem of scratching.

In summary, the present invention has the following beneficial effects:
First, the present invention employs a tubular PECVD device to deposit the rear composite film on the rear surface of the silicon wafer. The rear composite film includes one or more of an aluminum oxide film, a silicon dioxide film, a silicon oxynitride film, and a silicon nitride film. The tubular PERC device adopts a direct plasma method in which the plasma directly bombards the surface of the silicon wafer and causes significant passivation of the film. The tubular PECVD device includes four gas lines of silane, ammonia, trimethyl aluminum, and nitrous oxide, which are used alone or in combination to form the aluminum oxide film, the silicon dioxide film, the silicon oxynitride film, and the silicon nitride film. By employing different gas combinations, different ratios of the gas flow rate, and different deposition time, the four gas lines of silane, ammonia, trimethyl aluminum, and nitrous oxide may form different films. As to a silicon oxynitride film or a silicon nitride film, it is possible to obtain a silicon oxynitride film or a silicon nitride film having different composition ratios and refractive indexes by adjusting the ratio of the gas flow rate. The combination order, thickness, and composition of the composite film can be flexibly adjusted, and therefore the production process of the present invention is flexible and controllable; furthermore, it is possible to reduce cost and obtain a large yield with this production process. In addition, the rear composite film is optimized to match the all-aluminum rear electric field at the rear surface, which gives the best passivation effect and significantly increases the photoelectric conversion efficiency of the PERC cell.
Second, the present invention adjusts the diameters of the pin shaft and the pin base to reduce the depth of the inside of the pin slot. As a result, the gap between the silicon wafer and the pin base at the position of the pin is reduced. Further, the amount of gas reaching and coating the rear surface of the silicon wafer is reduced, and boat teeth marks at the front surface edges of the cell thus are much less likely to occur. In addition, the present invention adequately increases the angle of inclination of the inclined surface of the pin cap and the thickness of the pin cap, and adjusts the automatic wafer inserter, thereby slightly increasing the distance between the silicon wafer and the graphite boat wall on inserting the wafer, and reducing scratching. Increasing the angle of inclination of the inclined surface of the pin cap may also reduce the impact force on the silicon wafer from the graphite boat wall when the silicon wafer is sliding down, reducing breakage rate.

Furthermore, silicon nitride is the outer layer of the rear composite film; and as the deposition time increases, the thickness of the film at the surface of the silicon wafer increases, which causes silicon wafer to bend. As a result, it is easier for silane and ammonia to be coated to the front surface edge of the cell. In the present invention, the deposition temperature for silicon nitride is set to 390-410 °C, and the deposition time is set within 300-500s. By shortening the time and temperature of silicon nitride deposition, the bending of the silicon wafer can be reduced, and thus the amount of the undesirable coating can be reduced. The temperature window for silicon nitride deposition is very narrow, between 390-410 °C, which may allow the maximum reduction of the undesirable coating. When the deposition temperature is below 390°C, the amount of the undesirable coating increases, however.

Meanwhile, to meet the requirements of large-scale production and minimize the negative impact caused by shortening the silicon nitride deposition time, the present invention sets a laser power of 14W or more, a laser scribing speed of 20 m/s or more, and a frequency of 500 kHZ or more. This allows the absorption of a sufficiently large amount of laser energy per unit of area of the rear composite film to effectively groove the composite film, thereby ensuring that the aluminum paste subsequently printed is in contact with the silicon substrate through the laser grooving regions.

To conclude, the monofacial tube-type PERC solar cell of the present invention has high photoelectric conversion efficiency, high appearance quality, and high EL yield; and further, it solves the problems of both scratching and undesirable coating. In addition, the present invention also provides a method and a device for the production of the aforementioned cell. The production method is simple and compatible with existing production lines, and can be carried out at a large scale. The production device has a simple structure, low cost, large capacity and yield.

Finally, it should be noted that the above embodiments are only intended to illustrate the technical solutions of the present invention and are not intended to limit the scope of the present invention. Although the present invention has been described in detail with reference to the preferred embodiments, it should be appreciated by those of ordinary skill in the art that the technical solutions of the present invention may be modified or equivalently substituted without departing from the spirit and scope of the technical solutions of the present invention.

## Claims

1. A monofacial tube-type PERC solar cell, **characterized by** comprising a rear silver busbar, an all-aluminum rear electric field, a rear composite film, P-type silicon, an N-type emitter, a front passivation film, and a front silver electrode, wherein the all-aluminum rear electric field, rear composite film, the P-type silicon, the N-type emitter, the front passivation film, and the front silver electrode are stacked and connected sequentially from bottom to top;
wherein the rear composite film includes one or more of an aluminum oxide film, a silicon dioxide film, a silicon oxynitride film, and a silicon nitride film, and is deposited on a rear surface of a silicon wafer by a tubular PECVD device; the tubular PECVD device includes four gas lines of silane, ammonia, trimethyl aluminum, and nitrous oxide; the four gas lines are used alone or in combination to form the aluminum oxide film, the silicon dioxide film, the silicon oxynitride film, and the silicon nitride film; a graphite boat is employed to load and unload the silicon wafer in the tubular PECVD device; and a pin slot of the graphite boat has a depth of 0.5-1 mm; and
wherein 30-500 parallel-arranged laser grooving regions are formed in the rear composite film by laser grooving; each of the laser grooving regions includes at least one group of laser grooving units; and the all-aluminum rear electric field is connected to the P-type silicon via the laser grooving regions.

2. The monofacial tube-type PERC solar cell according to claim 1, wherein the pin slot of the graphite boat has a depth of 0.6-0.8 mm, a diameter of a pin base is 6-15 mm, an angle of inclination of an inclined surface of a pin cap is 35-45 degrees, and a thickness of the pin cap is 1-1.3 mm.

3. The monofacial tube-type PERC solar cell according to claim 1, wherein 3-5 pin marks are formed on the rear surface of the monofacial tube-type PERC solar cell.

4. The monofacial tube-type PERC solar cell according to claims 1, 2 or 3, wherein a bottom layer of the rear composite film is the aluminum oxide film, and a top layer of the rear composite film is composed of one or more of the silicon dioxide film, the silicon oxynitride film, and the silicon nitride film.

5. The monofacial tube-type PERC solar cell according to claims 1, 2 or 3, wherein a bottom layer of the rear composite film is the silicon dioxide film, a middle layer of the rear composite film is the aluminum oxide film, and a top layer of the rear composite film is composed of one or more of the silicon dioxide film, the silicon oxynitride film, and the silicon nitride film.

6. The monofacial tube-type PERC solar cell according to claim 1, wherein a thickness of the aluminum oxide film is 5-15 nm, a thickness of the silicon nitride film is 50-150 nm, a thickness of the silicon oxynitride film is 5-20 nm, and a thickness of the silicon dioxide film is 1-10 nm.

7. A method of preparing the monofacial tube-type PERC solar cell according to any one of claims 1-6, **characterized by** comprising:
(1) forming textured surfaces at a front surface and the rear surface of the silicon wafer, wherein the silicon wafer is the P-type silicon;
(2) performing diffusion via the front surface of the silicon wafer to form the N-type emitter;
(3) removing phosphosilicate glass and peripheral p-n junctions formed during the diffusion, and polishing the rear surface of the silicon wafer, wherein a depth of rear etching is 3-6 µm;
(4) performing annealing on the silicon wafer, wherein an annealing temperature is 600-820°C, a nitrogen flow rate is 1-15 L/min, and an oxygen flow rate is 0.1-6 L/min;
(5) depositing the rear composite film on the rear surface of the silicon wafer by the tubular PECVD device, including:
depositing the aluminum oxide film using TMA and N₂O, wherein a gas flow rate of TMA is 250-500 sccm, a ratio of TMA to N₂O is 1 to 15-25, and a plasma power is 2000-5000W;
depositing the silicon oxynitride film using silane, ammonia, and nitrous oxide, wherein a gas flow rate of silane is 50-200 sccm, a ratio of silane to nitrous oxide is 1 to 10-80, a flow rate of ammonia is 0.1-5 slm, and the plasma power is 4000-6000W;
depositing the silicon nitride film using silane and ammonia, wherein the gas flow rate of silane is 500-1000 sccm, a ratio of silane to ammonia is 1 to 6-15, a deposition temperature of silicon nitride is 390-410 °C, a deposition time is 300-500s, and the plasma power is 10000-13000W; and
depositing the silicon dioxide film using nitrous oxide, wherein a flow rate of nitrous oxide is 0.1-5 slm, and the plasma power is 2000-5000W;
wherein the tubular PECVD device includes four gas lines of silane, ammonia, trimethyl aluminum, and nitrous oxide, the graphite boat is employed to load and unload the silicon wafer in the tubular PECVD device, and the pin slot of the graphite boat has a depth of 0.5-1 mm;
(6) depositing a passivation film on the front surface of the silicon wafer;
(7) performing laser grooving in the rear composite film of the silicon wafer;
wherein a laser wavelength is 532 nm, a laser power is 14W or more, a laser scribing speed is 20 m/s or more, and a frequency is 500 kHZ or more;
(8) printing with a paste for the rear silver busbar on the rear surface of the silicon wafer, and baking;
(9) printing, using a screen, aluminum paste on the rear surface of the silicon wafer, and baking;
(10) printing with a paste for the front silver electrode on the front surface of the silicon wafer;
(11) sintering the silicon wafer at a high temperature to form the rear silver busbar, the all-aluminum rear electric field, and the front silver electrode; and
(12) performing anti-LID annealing on the silicon wafer to obtain the monofacial tube-type PERC solar cell.

8. The method according to claim 7, wherein depositing the rear composite film on the rear surface of the silicon wafer by the tubular PECVD device comprises:
depositing the aluminum oxide film using TMA and N₂O, wherein the gas flow rate of TMA is 250-500 sccm, the ratio of TMA to N₂O is 1 to 15-25, a deposition temperature of the aluminum oxide film is 250-300 °C, a deposition time is 50-300s, and the plasma power is 2000-5000W;
depositing the silicon oxynitride film using silane, ammonia, and nitrous oxide, wherein the gas flow rate of silane is 50-200 sccm, the ratio of silane to nitrous oxide is 1 to 10-80, the flow rate of ammonia is 0.1-5 slm, a deposition temperature of the silicon oxynitride film is 350-410 °C, a deposition time is 50-200s, and the plasma power is 4000-6000W;
depositing the silicon nitride film using silane and ammonia, wherein the gas flow rate of silane is 500-1000 sccm, the ratio of silane to ammonia is 1 to 6-15, the deposition temperature of the silicon nitride film is 390-410 °C, the deposition time is 300-500s, and the plasma power is 10000-13000W; and
depositing the silicon dioxide film using nitrous oxide, wherein the flow rate of nitrous oxide is 0.1-5 slm, and the plasma power is 2000-5000W.

9. A device for producing the monofacial tube-type PERC solar cell according to any one of claims 1-6, which is a tubular PECVD device, **characterized by** comprising a wafer loading area, a furnace body, a gas cabinet, a vacuum system, a control system, and a graphite boat, the gas cabinet including a first gas line for feeding silane, a second gas line for feeding ammonia, a third gas line for feeding trimethylaluminum, and a fourth gas line for feeding nitrous oxide;
wherein the graphite boat is employed for loading and unloading the silicon wafer, wherein the graphite boat includes a pin which includes a pin shaft, a pin cap connected to the pin shaft, and a pin base on which the pin shaft is mounted, and wherein a pin slot is formed among the pin shaft, the pin cap, and the pin base, and a depth of the pin slot is 0.5-1 mm.

10. The device according to claim 9, wherein the depth of the pin slot is 0.6-0.8 mm, a diameter of the pin base is 6-15 mm, an angle of inclination of an inclined surface of the pin cap is 35-45 degrees, and a thickness of the pin cap is 1-1.3 mm.
